(19) Europäisches Patentamt
European Patent Office
Office européen des brevets

(11) Veröffentlichungsnummer: **0 321 826 B1**

(12) **EUROPÄISCHE PATENTSCHRIFT**

(45) Veröffentlichungstag der Patentschrift: **03.11.93**

(51) Int. Cl.$^5$: **G03F 7/029**

(21) Anmeldenummer: **88120773.2**

(22) Anmeldetag: **13.12.88**

# (54) Photopolymerisierbares Gemisch und daraus hergestelltes Aufzeichnungsmaterial.

(30) Priorität: **22.12.87 DE 3743454**

(43) Veröffentlichungstag der Anmeldung:
**28.06.89 Patentblatt 89/26**

(45) Bekanntmachung des Hinweises auf die Patenterteilung:
**03.11.93 Patentblatt 93/44**

(84) Benannte Vertragsstaaten:
**DE FR GB NL**

(56) Entgegenhaltungen:
**EP-A- 0 014 293**
**EP-A- 0 097 012**
**EP-A- 0 223 373**
**EP-A- 0 287 817**
**DE-A- 2 027 467**
**DE-A- 2 125 457**
**DE-A- 2 361 041**
**DE-A- 2 822 190**
**DE-A- 3 333 450**
**DE-A- 3 602 093**
**FR-A- 2 375 256**
**GB-A- 1 165 570**
**GB-A- 1 193 923**
**JP-A-61 228 002**
**US-A- 3 479 185**
**US-A- 4 399 211**

**RESEARCH DISCLOSURE, Nr. 2244, Dezember 1980, Seiten 560-565, Zusammenfassung Nr. 20036, Havant, Hampshire, GB; "Photopolymerizable compositions featuring novel co-initiators"**

(73) Patentinhaber: **HOECHST AKTIENGESELLSCHAFT**

**D-65926 Frankfurt(DE)**

(72) Erfinder: **Rode, Klaus, Dr.**
**Habelstrasse 5**
**D-6200 Wiesbaden(DE)**
Erfinder: **Gerstorf, Joachim, Dr.**
**Phillip-Holl-Strasse 26**
**D-6200 Wiesbaden(DE)**
Erfinder: **Mohr, Dieter, Dr.**
**Eaubonner Strasse 8**
**D-6501 Budenheim(DE)**
Erfinder: **Frass, Werner, Dr.**
**Erbsenacker**
**D-6200 Wiesbaden-Naurod(DE)**

**EP 0 321 826 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein photopolymerisierbares Gemisch, das ein polymeres Bindemittel, eine polymerisierbare Verbindung mit mindestens zwei Acryl- oder Alkacrylsäureestergruppen im Molekül sowie eine Photoinitiatorkombination enthält.

Photopolymerisierbare Gemische, die zur Erhöhung der Lichtempfindlichkeit bestimmte Kombinationen von Photoinitiatoren und Aktivatoren, z. B. von Carbonylgruppen enthaltenden Initiatoren und tertiären Aminen, enthalten, sind bekannt. Derartige synergistisch wirkende Gemische sind z. B. in den DE-A 26 02 419 und 22 51 048 und der US-A 3 759 807 beschrieben. Ein Nachteil dieser Gemische, die niedermolekulare Amine enthalten, besteht darin, daß sie eine geringere Lagerstabilität aufweisen, da die Amine, insbesondere aus dünnen Schichten, leicht ausschwitzen können.

In der JP-A 50/129 214, angemeldet am 2.4.1974 unter der Nummer 49/36614, wird ein photopolymerisierbares Gemisch beschrieben, das als polymerisierbare Verbindung einen Tetra(meth)acrylsäureester eines N,N,N',N'-Tetrahydroxyalkyl-alkylendiamins enthält. Die tetrafunktionelle Verbindung dient als Vernetzungsmittel.

Es sind auch Gemische bekannt, die als Vernetzer Triethanolamintrimethacrylat enthalten und z. B. in Chem. Abstr. 86 (1977), 30443q und 95 (1981), 220 727u beschrieben sind. Auch diese Verbindungen neigen bei längerer Lagerung und bei erhöhter Umgebungstemperatur dazu, aus der Schicht auszuschwitzen und zu verdampfen.

Es ist weiterhin bekannt, daß man die radikalische Polymerisation von ethylenisch ungesättigten Verbindungen durch Bestrahlung mit sichtbarem Licht in Gegenwart von photoreduzierbaren Farbstoffen und Reduktionsmitteln, z. B. Aminen, anstoßen kann (US-A 3 097 096). Diese Initiatorkombinationen werden jedoch im wesentlichen nur in wäßriger Lösung oder in Kombination mit wasserlöslichen Bindemitteln eingesetzt.

Initiatorkombinationen aus photoreduzierbaren Farbstoffen und anderen Reduktionsmitteln sind in den US-A 3 597 343 und 3 488 269 beschrieben. Photopolymerisierbare Gemische, die als Initiatoren ausschließlich photoreduzierbare Farbstoffe enthalten, sind wegen ihrer zu geringen Lichtempfindlichkeit bisher praktisch nicht eingesetzt worden.

In der JP-A 54/151 024 ist ein photopolymerisierbares Gemisch beschrieben, das eine Initiatorkombination aus einem Merocyaninfarbstoff und einem trihalogenmethylsubstituierten s-Triazin enthält und gegenüber sichtbarem Licht, z. B. einem Argonlaser, empfindlich ist. Die Empfindlichkeit dieser Gemische gegenüber sichtbarem Laserlicht ist jedoch für eine wirtschaftliche Nutzung nicht ausreichend.

In der älteren deutschen Patentanmeldung P 37 10 281.8 wird ein photopolymerisierbares Gemisch vorgeschlagen, das aus einem polymeren Bindemittel, einem Acryl- oder Methacrylsäureester mit mindestens einer photooxydierbaren Gruppe und mindestens einer Urethangruppe im Molekül, einem photoreduzierbaren Farbstoff, einer durch Strahlung spaltbaren Trihalogenmethylverbindung und einer als Photoinitiator wirksamen Acridin-, Phenazin- oder Chinoxalinverbindung besteht.

Aufgabe der Erfindung war es, photopolymerisierbare Gemische vorzuschlagen, die sich zur Herstellung von Druckplatten hoher Auflagenleistung und Photoresists mit hoher Resistenz gegen Verarbeitungslösungen im gehärteten Zustand eignen, die sich durch eine hohe Lichtempfindlichkeit im nahen Ultraviolett- und im sichtbaren Spektralbereich auszeichnen und daher insbesondere zur Laserstrahlaufzeichnung im sichtbaren Bereich geeignet sind.

Erfindungsgemäß wird ein photopolymerisierbares Gemisch vorgeschlagen, das als wesentliche Bestandteile

a) ein polymeres Bindemittel,
b) einen Acryl- oder Alkacrylsäureester eines mehrwertigen Alkohols und
c) einen photoreduzierbaren Farbstoff als Photoinitiator enthält.

Das erfindungsgemäße Gemisch ist dadurch gekennzeichnet, daß es ferner

d) eine durch Strahlung spaltbare Trihalogenmethylverbindung und
e) eine als Photoinitiator wirksame Acridin-, Phenazin- oder Chinoxalinverbindung enthält

und daß der Acryl- oder Alkacrylsäureester mindestens eine bei Belichtung in Gegenwart des photoreduzierbaren Farbstoffs photooxydierbare Gruppe, aber keine Urethangruppe aufweist.

Als photooxydierbare Gruppen kommen insbesondere Aminogruppen, Thiogruppen, die auch Bestandteile heterocyclischer Ringe sein können, Enolgruppen und Carboxylgruppen in Kombination mit olefinischen Doppelbindungen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt.

Mit besonderem Vorteil werden Acryl- und Alkacrylsäureester der Formel I

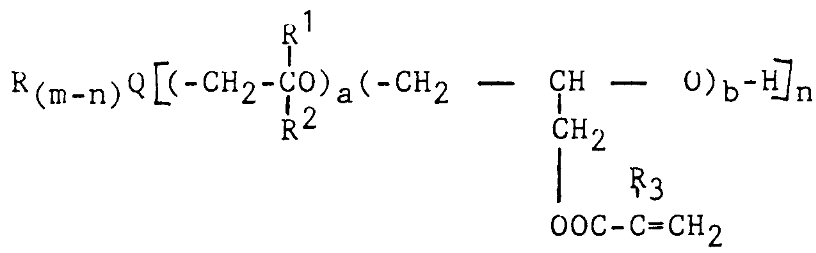

(I)

eingesetzt, worin

Q

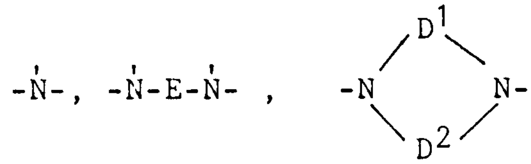

| | |
|---|---|
| | oder -S-, |
| R | eine Alkyl-, Hydroxyalkyl- oder Arylgruppe, |
| $R^1$ und $R^2$ | jeweils ein Wasserstoffatom, eine Alkylgruppe oder Alkoxyalkylgruppe, |
| $R^3$ | ein Wasserstoffatom, eine Methyl- oder Ethylgruppe, |
| $D^1$ und $D^2$ | jeweils eine gesättigte Kohlenwasserstoffgruppe mit 1 bis 5 Kohlenstoffatomen, |
| E | eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen, eine heterocyclische aromatische Gruppe mit 5 oder 6 Ringgliedern oder eine Gruppe der Formel II |

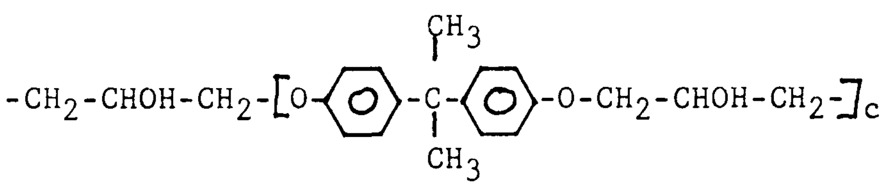

(II),

| | |
|---|---|
| a und b | ganze Zahlen von 1 bis 4, |
| c | eine ganze Zahl von 1 bis 3, |
| m | je nach Wertigkeit von Q 2, 3 oder 4 und |
| n | eine ganze Zahl von 1 bis m |

bedeutet, wobei alle Reste gleicher Definition untereinander gleich oder verschieden sein können.

Die Verbindungen dieser Formel, ihre Herstellung und Verwendung sind ausführlich in der älteren Patentanmeldung P 37 38 864.9 beschrieben.

In der gleichzeitig eingereichten Patentanmeldung P 37 43 455.1 (Hoe 87/K083) sind photopolymerisierbare Gemische beschrieben, die diese polymerisierbaren Verbindungen in Kombination mit photoreduzierbaren Farbstoffen und durch Strahlung spaltbaren Trihalogenmethylverbindungen als Photoinitiatorsysteme enthalten.

In der weiteren gleichzeitig eingereichten Patentanmeldung P 37 43 457.8 (Hoe 87/K084) sind photopolymerisierbare Gemische beschrieben, die diese und andere photooxydierbare polymerisierbare Verbindungen in Kombination mit bestimmten photoreduzierbaren Benzoxanthen- oder Benzothioxanthenfarbstoffen und durch Strahlung spaltbaren Trihalogenmethylverbindungen enthalten.

Wenn in der Verbindung der allgemeinen Formel I mehr als ein Rest R oder mehr als ein Rest des in eckigen Klammern angegebenen Typs an die zentrale Gruppe Q gebunden ist, so können diese Reste untereinander verschieden sein.

Verbindungen, in denen alle Substituenten von Q polymerisierbare Reste sind, d. h. in denen m = n ist, werden im allgemeinen bevorzugt.

Vorzugsweise ist a = 1.

Wenn R eine Alkyl- oder Hydroxyalkylgruppe ist, hat diese im allgemeinen 2 bis 8, vorzugsweise 2 bis 4 Kohlenstoffatome. Der Arylrest R kann im allgemeinen ein- oder zweikernig, bevorzugt einkernig und gegebenenfalls durch Alkyl- oder Alkoxygruppen mit bis zu 5 Kohlenstoffatomen oder Halogenatome substituiert sein.

Wenn $R^1$ und $R^2$ Alkyl- oder Alkoxyalkylgruppen sind, können diese je 1 bis 5 Kohlenstoffatome enthalten.

$R^3$ ist bevorzugt ein Wasserstoffatom oder eine Methylgruppe, insbesondere eine Methylgruppe.

$D^1$ und $D^2$ können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese vorzugsweise 2 bis 6 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt.

Der Wert von c ist vorzugsweise 1.

Die polymerisierbaren Verbindungen der Formel I mit Q = N und n = m werden hergestellt, indem Acryl- oder Alkacrylsäureglycidylester in bekannter Weise in Gegenwart eines basischen Katalysators, z. B. Natrium oder Natriumhydrid, mit Hydroxyalkylaminen umgesetzt werden. Die Umsetzung kann analog zu der in der DE-A 29 27 933 oder der DE-B 18 00 462 beschriebenen Umsetzung von Glycidyl(meth)acrylat mit Alkoholen durchgeführt werden.

Die als Ausgangsstoffe verwendeten Hydroxyalkylamine sind bekannt oder analog bekannten Verbindungen herzustellen. Beispiele sind Verbindungen, die durch Anlagerung von Ethylenoxid bzw. von höheren Alkylenoxiden an Ammoniak oder Amine entstehen; z. B. Triethanolamin, N-Alkyl-N,N-di(hydroxyalkyl)amine, Diethanolamin, Tris-(2-hydroxypropyl)amin oder Tris-(2-hydroxybutyl)amin.

Die polymerisierbaren Verbindungen der Formel I mit

Q =

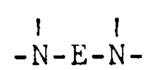

und n = 4

werden analog den polymerisierbaren Verbindungen mit Q = N hergestellt. Die als Ausgangsstoffe verwendeten Tetrahydroxyalkyl-alkylendiamine sind bekannt oder analog zu bekannten Verbindungen herzustellen. Beispiele sind Verbindungen, die durch Anlagerung von Ethylenoxid oder höheren Alkylenoxiden an Diaminoverbindungen entstehen, z. B. an Ethylendiamin und andere Alkylendiamine mit bis zu 12, vorzugsweise bis zu 6 Kohlenstoffatomen im Alkylenrest, p-Phenylendiamin, Benzidin, Diaminopyridine, Diaminopyrimidine, Diaminopurine.

Die polymerisierbaren Verbindungen der Formel I mit

Q =

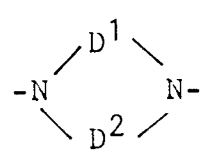

werden analog den oben beschriebenen polymerisierbaren Verbindungen hergestellt. Die als Ausgangsstoffe verwendeten N-Hydroxyalkylheterocyclen sind bekannt oder analog zu bekannten Verbindungen herzustellen. Beispiele sind Umsetzungsprodukte des Ethylenoxids mit Piperazin, 1,4-Diazacycloheptan, 1,10-Diaza-4,7,13,16-tetraoxacyclooctadecan.Insbesondere wird Piperazin eingesetzt, da es der einfachste Vertreter dieser Verbindungsgruppe ist.

Die Umsetzung der Acryl- oder Alkacrylsäureglycidylester mit den OH-Gruppen enthaltenden Aminen wird zweckmäßig in einem inerten Lösungsmittel wie Toluol oder Methylethylketon durchgeführt. Zur thermischen Stabilisierung der stark zur Polymerisation neigenden Produkte werden Chinone, vorzugsweise Benzochinon, in Konzentrationen von 0,01 - 2 Gew.-% zugesetzt.

Die Verbindungen mit Q = S werden, ausgehend vom entsprechenden Bis-hydroxyalkyl-sulfid, analog den oben angegebenen allgemeinen Vorschriften hergestellt.

Neben anderen Bestandteilen sind die vorstehend beschriebenen polymerisierbaren Verbindungen für die sehr hohe Lichtempfindlichkeit der photopolymerisierbaren Gemische verantwortlich.

Außer den beschriebenen photooxydierbaren polymerisierbaren Verbindungen können auch herkömmliche polymerisierbare Verbindungen, die zwei oder mehr polymerisierbare Acryl- oder Methacrylsäureestergruppen enthalten, zugesetzt werden. Beispiele sind Acryl- und Methacrylsäureester von zwei-oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-A 20 64 079, 23 61 041 und 28 22 190 beschrieben.

Der Mengenanteil des Gemischs an Monomeren beträgt im allgemeinen etwa 10 bis 80, vorzugsweise 20 bis 60 Gew.-%.

Das erfindungsgemäße Gemisch enthält als Photoinitiatorbestandteil einen photoreduzierbaren Farbstoff. Geeignete Farbstoffe sind insbesondere Xanthen-, Thiazin-, Porphyrin- oder Acridinfarbstoffe. Bevorzugte Vertreter der Xanthenfarbstoffe sind Verbindungen der allgemeinen Formel III

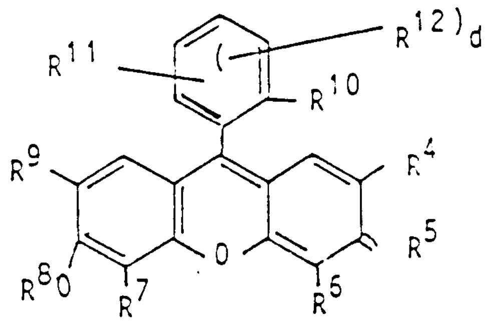

(III)

worin

| | |
|---|---|
| $R^4$ und $R^9$ | gleich oder verschieden sind und Wasserstoff- oder Halogenatome, Nitro- oder Hydroxygruppen oder Gruppen der Formel -HgOH bedeuten, |
| $R^6$ und $R^7$ | gleich oder verschieden sind und Wasserstoff- oder Halogenatome oder Hydroxygruppen, |
| $R^5$ | O oder $^{(+)}$NHAlkyl $X^{(-)}$, |
| $R^8$ | ein Wasserstoffatom, ein Alkalimetall-, Ammonium- oder Trialkylammoniumkation, eine Alkyl- oder Acylgruppe, |
| $R^{10}$ | ein Wasserstoffatom oder eine Gruppe $COOR^{13}$, |
| $R^{11}$ | ein Wasserstoff- oder Halogenatom oder eine Aminogruppe, |
| $R^{12}$ | ein Wasserstoff- oder Halogenatom, |
| $R^{13}$ | ein Wasserstoffatom, ein Alkalimetall- oder Ammoniumkation, eine Alkylgruppe oder ein polymerer Rest, |
| X | ein Anion und |
| d | Null oder eine ganze Zahl von 1 bis 3 bedeutet. |

Wenn die Reste $R^5$, $R^8$ und $R^{13}$ Alkylreste sind oder solche enthalten, haben diese im allgemeinen 1 bis 25, insbesondere 1 bis 18 Kohlenstoffatome.

Geeignete Thiazinfarbstoffe sind Verbindungen der Formel (IV)

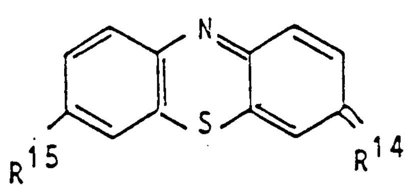

(IV)

worin

$R^{14}$ eine der Gruppen $=NH_2^{(+)}X^{(-)}$, $=NHAlkyl^{(+)}X^{(-)}$ und $=N(Alkyl)_2^{(+)}X^{(-)}$,

$R^{15}$ eine Amino-, Alkylamino- oder Dialkylaminogruppe und

X ein Anion ist.

In der Formel IV haben Alkylgruppen die gleiche Bedeutung wie in der Formel III.

Als Porphyrinfarbstoff ist z. B. Hämatoporphyrin und als Acridinfarbstoff z. B. Acriflaviniumchlorid-Hydrochlorid geeignet. Beispiele für Verbindungen der Formel III sind Eosin B (C.I. Nr. 45 400), Eosin J (C.I. Nr. 45 380), Eosin alkohollöslich (C.I. 45 386), Cyanosin (C.I. Nr. 45 410), Bengalrosa, Erythrosin (C.I. Nr. 45 430), 2,3,7-Trihydroxy-9-phenyl-xanthen-6-on und Rhodamin 6 G (C.I. Nr. 45 160).

Beispiele für Verbindungen der Formel IV sind Thionin (C.I. Nr. 52 000), Azur A (C.I. Nr. 52 005) und Azur C (C.I. Nr. 52 002).

Die Menge der Komponente (c) des Gemischs liegt im allgemeinen zwischen 0,01 und 10, vorzugsweise zwischen 0,05 und 4 Gew.-%, bezogen auf die nichtflüchtigen Anteile des Gemischs.

Zur Steigerung der Lichtempfindlichkeit enthalten die erfindungsgemäßen Gemische Verbindungen mit photolytisch spaltbaren Trihalogenmethylgruppen (d), die als radikalbildende Photoinitiatoren für photopolymerisierbare Gemische an sich bekannt sind. Als derartige Coinitiatoren haben sich besonders Verbindungen mit Chlor und Brom, insbesondere Chlor, als Halogene bewährt. Die Trihalogenmethylgruppen können direkt oder über eine durchkonjugierte Kette an einen aromatischen carbo- oder heterocyclischen Ring gebunden sein. Bevorzugt werden Verbindungen mit einem Triazinring im Grundkörper, der bevorzugt 2 Trihalogenmethylgruppen trägt, insbesondere solche, wie sie in der EP-A 137 452, der DE-A 27 18 259 und der DE-A 22 43 621 beschrieben sind. Diese Verbindungen haben starke Lichtabsorptionen im nahen UV-Bereich, etwa um 350-400 nm. Es sind auch Coinitiatoren geeignet, die selbst im Spektralbereich des Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z. B. Phenyl-trihalogenmethyl-sulfone oder Phenyl-trihalogenmethyl-ketone, z. B. das Phenyl-tribrommethylsulfon, sind geeignet. Ferner eignen sich Trihalogenmethylgruppen enthaltende Carbonylmethylenheterocyclen, wie sie in der DE-A 33 33 450 beschrieben sind.

Die Komponenten (d) werden im allgemeinen in einer Menge von 0,01 bis 10, vorzugsweise von 0,05 bis 6 Gew.-%, bezogen auf die nichtflüchtigen Bestandteile des Gemischs, eingesetzt.

Die erfindungsgemäßen Gemische enthalten als weiteren Initiatorbestandteil eine Acridin-, Phenazin- oder Chinoxalinverbindung (e). Diese Verbindungen sind als Photoinitiatoren bekannt und in den DE-C 20 27 467 und 20 39 861 beschrieben. Durch diese Verbindungen wird die Empfindlichkeit des Gemischs vor allem im nahen Ultraviolettbereich gesteigert. Geeignete Vertreter dieser Verbindungsklasse sind in den genannten DE-C beschrieben. Beispiele sind in 9-Stellung substituierte Acridine, wie 9-Phenyl-, 9-p-Methoxyphenyl- oder 9-Acetylamino-acridin, oder Acridinderivate mit ankondensierten aromatischen Kernen, z. B. Benz(a)acridin. Als Phenazinderivat ist z. B. das 9,10-Dimethyl-benz(a)phenazin geeignet.

Als Chinoxalinderivate kommen insbesondere die 2,3-Diphenylderivate in Betracht, die vorzugsweise in den beiden Phenylresten durch Methoxygruppen weiter substituiert sind. Im allgemeinen werden als Komponenten (e) die Acridinderivate bevorzugt.

Die Menge der Komponente (e) im Gemisch liegt ebenfalls im Bereich von 0,01 bis 10 Gew.-%, vorzugsweise zwischen 0,05 und 5 Gew.-%.

Wenn eine weitere Empfindlichkeitssteigerung des Gemischs im sichtbaren Spektralbereich erwünscht ist, kann diese durch Zusatz einer Verbindung (f) vom Dibenzalaceton- oder Cumarintyp erreicht werden. Dieser Zusatz bewirkt eine höhere Auflösung der Kopie und eine durchgehende Sensibilisierung des Gemischs für den sichtbaren Spektralbereich bis zu Wellenlängen von etwa 600 nm. Geeignete Vertreter dieser Verbindungen sind 4,4'-disubstituierte Dibenzalacetone, z. B. 4-Diethylamino-4'-methoxy-dibenzalaceton, oder Cumarinderivate wie 3-Acetyl-7-diethylamino-, 3-Benzimidazolyl-7-diethylamino- oder Carbonyl-bis-(7-diethylaminocumarin). Die Menge der Verbindung (f) liegt ebenfalls im Bereich von 0,01 bis 10, vorzugsweise von 0,05 bis 4 Gew.-%, bezogen auf die nichtflüchtigen Bestandteile des Gemischs.

Die Gesamtmenge an Polymerisationsinitiatoren (c), (d) und (e) oder ggf. die Gesamtmenge einschließlich der Komponente (f) liegt im allgemeinen bei 0,05 bis 20, vorzugsweise bei 0,1 bis 10 Gew.-%. Das Molverhältnis der Bestandteile (c), (d), (e) und (f) untereinander liegt bevorzugt in den folgenden Bereichen (c) : (d) : (e) : (f) = 1 : (4-10) : (1-5) : (0-4).

Als Bindemittel können eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid und Mischpolymerisate der Monomeren, die die aufgezählten Homopolymerisate bilden, sowie Blockmischpolymerisate von Vinylaromaten, z. B. Styrol, und Dienen, z. B. Butadien oder Isopren.

Mit Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten: -COOH, $-PO_3H_2$, $-SO_3H$; $-SO_2NH-$, $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-$\beta$-(methacryloyloxy)-ethylester und Mischpolymerisate dieser und ähnlicher Monomerer mit anderen Monomeren sowie Vinylacetat/Crotonsäure- und Styrol/Maleinsäureanhydrid-Mischpolymerisate. Alkylmethacrylat/Methacrylsäure-Mischpolymerisate und Mischpolymerisate aus Methacrylsäure, höheren Alkylmethacrylaten und Methylmethacrylat und/oder Styrol, Acrylnitril u. a., wie sie in den DE-A 20 64 080 und 23 63 806 beschrieben sind, werden bevorzugt.

Die Menge des Bindemittels beträgt im allgemeinen 20 bis 90, vorzugsweise 30 bis 80 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger. Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung, Laserstrahlung, Elektronen- und Röntgenstrahlung.

Das photopolymerisierbare Gemisch kann für die verschiedensten Anwendungen Einsatz finden, beispielsweise zur Herstellung von Lacken, die durch Licht gehärtet werden, als Zahnfüll- oder -ersatzmaterial und insbesondere als lichtempfindliches Aufzeichnungsmaterial auf dem Reproduktionsgebiet. Als Anwendungsmöglichkeiten auf diesem Gebiet seien genannt: Aufzeichnungsschichten für die photomechanische Herstellung von Druckformen für den Hochdruck, den Flexodruck, den Flachdruck, den Tiefdruck, den Siebdruck, von Reliefkopien, z. B. von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Aufzeichnungsschichten für die Herstellung von Druckplatten und für die Photoresisttechnik.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. H. für die Herstellung von Druckplatten, vorliegen. Ebenso ist es für die Herstellung von Trockenresist geeignet.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. H. Wachse, Polyamide, Polyvinylalkohol, Polyphosphate, Zucker usw.. Solche Deckschichten haben im allgemeinen eine Dicke von 0,1 bis 10, vorzugsweise 1 bis 5 $\mu$m.

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Cellulosacetat, sowie Siebdruckschablonenträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien unter Verwendung des erfindungsgemäßen Gemischs erfolgt in bekannter Weise. So kann man dieses in einem Lösemittel aufnehmen und die Lösung bzw. Dispersion durch Gießen, Sprühen, Tauchen, Antrag mit Walzen usw. auf den vorgesehenen Träger

aufbringen und anschließend trocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und getrocknet. Die lichtempfindlichen Schichten - Dicke etwa zwischen 10 und 100 µm - werden dann gleichfalls zunächst zusammen mit dem temporären Träger auf das gewünschte Substrat auflaminiert.

Durch die breite spektrale Empfindlichkeit des erfindungsgemäßen Gemisches können alle dem Fachmann geläufigen Lichtquellen verwendet werden, z. B. Röhrenlampen, Xenonimpulslampen, metallhalogeniddotierte Quecksilberdampf-Hochdrucklampen und Kohlenbogenlampen. Darüber hinaus ist bei den erfindungsgemäßen lichtempfindlichen Gemischen das Belichten in üblichen Projektions- und Vergrößerungsgeräten unter dem Licht der Metallfadenlampen und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren. Der Laserstrahl kann mittels einer vorgegebenen programmierten Strich- und/oder Raster-Bewegung gesteuert werden.

Die weitere Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben.

Im folgenden werden Ausführungsbeispiele für die Erfindung angegeben. Dabei wird zunächst in Tabelle I eine Anzahl von polymerisierbaren Verbindungen der Formel I aufgeführt, die in den Beispielen eingesetzt werden.

Die Herstellung dieser Verbindungen erfolgt nach einem der vorstehend angegebenen Verfahren. Die Verbindungen werden in den nachfolgenden Beispielen in erfindungsgemäßen Aufzeichnungsmaterialien als polymerisierbare Verbindungen eingesetzt. In den Beispielen stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

Tabelle I

Verbindungen der allgemeinen Formel I mit $R^2$=H; $R^3$=$CH_3$; m=n; a=1;

| Verb. Nr. | Q | R | $R^1$ | m |
|---|---|---|---|---|
| 1 | -N- | - | H | 3 |
| 2 | $-N-CH_2-CH_2-N-$ | - | $CH_3$ | 4 |
| 3 | " | - | H | 4 |
| 4 | -S- | - | H | 2 |
| 5 | *) | - | H | 4 |

*) 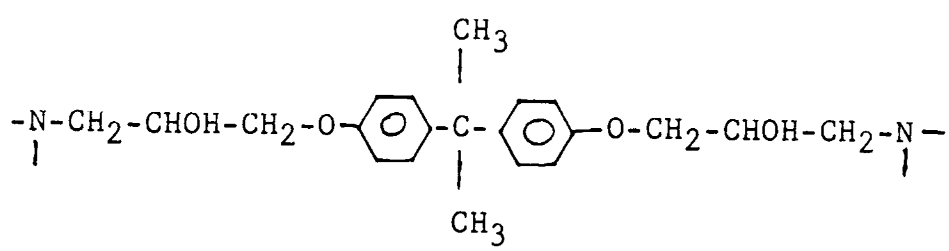

Beispiel 1

Als Schichtträger für Druckplatten wurde elektrochemisch aufgerauhtes und anodisiertes Aluminium mit einer Oxidschicht von 3 g/$m^2$ verwendet, das mit einer wäßrigen Lösung von Polyvinylphosphonsäure vorbehandelt worden war. Der Träger wurde mit einer Lösung folgender Zusammensetzung überzogen:
4,0 Gt einer 34,8 %igen Lösung eines Mischpolymerisats aus Methylmethacrylat und Methacrylsäure mit der Säurezahl 110 und dem mittleren Molekulargewicht 35 000 in Butanon,
1,4 Gt Monomeres gemäß Tabelle II,
0,02 Gt Eosin alkohollöslich (C.I. 45 386),
0,03 Gt 2,4-Bis-trichlormethyl-6-(4-styrylphenyl)-s-triazin und
0,049 Gt 9-Phenylacridin in
22 Gt Propylenglykolmonomethylether.

Das Auftragen erfolgte durch Aufschleudern in der Weise, daß ein Trockengewicht von 1,8 bis 2 g/$m^2$ erhalten wurde. Anschließend wurde die Platte zwei Minuten bei 100° C im Umlufttrockenschrank getrocknet. Die Platte wurde dann mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 4 bis

5 g/m$^2$ erhalten. Die erhaltene Druckplatte wurde mittels einer 5 kW-Metallhalogenidlampe im Abstand von 110 cm unter einem 13-stufigen Belichtungskeil mit Dichteinkrementen von 0,15 belichtet, auf den, soweit angegeben, zusätzlich ein Silberfilm mit gleichmäßiger Schwärzung (Dichte 1,57) und gleichmäßiger Absorption über den wirksamen Spektralbereich als Graufilter montiert wurde. Um die Empfindlichkeit der Druckplatte im sichtbaren Licht zu testen, wurden auf den Belichtungskeil jeweils 3 mm starke Kantenfilter der Firma Schott mit den in der Tabelle angegebenen Kantendurchlässigkeiten montiert. Nach der Belichtung wurde die Platte eine Minute auf 100° C erwärmt. Anschließend wurde sie mit einem Entwickler folgender Zusammensetzung entwickelt:

8,5 Gt Natriummetasilikat x 9 $H_2O$,
0,8 Gt NaOH und
1,5 Gt $Na_2B_4O_7$ x 10 $H_2O$ in
89,2 Gt vollentsalztes Wasser.

Die Platte wurde mit fetter Druckfarbe eingefärbt. Es wurden die folgenden vollvernetzten Keilstufen erhalten:

Tabelle II

| Verbindung | Belichtung (Sekunden) | Graufilter | Kantenfilter | Keilstufen |
|---|---|---|---|---|
| 1 | 5 | ja | - | 3 |
| | 5 | nein | 455 | 4 |
| 2 | 40 | ja | - | 4 |
| | 40 | nein | 455 | 4 |
| 3 | 40 | ja | - | 1 |
| | 40 | nein | 455 | 2 |
| 4 | 40 | ja | - | 6 |
| | 40 | nein | 455 | 7 |
| 5 | 40 | ja | - | 3 |
| | 40 | nein | 455 | 4 |

## Beispiel 2

Auf den in Beispiel 1 angegebenen Schichtträger wurde unter gleichen Bedingungen wie im Beispiel 1 eine Lösung folgender Zusammensetzung so aufgeschleudert, daß ein Schichtgewicht von 2,5 g/m$^2$ erhalten wurde:

4,0 Gt der in Beispiel 1 angegebenen Copolymerisatlösung,
1,4 Gt Verbindung 1,
0,02 Gt Farbstoff,
0,03 Gt des in Beispiel 1 angegebenen s-Triazins und
0,049 Gt 9-Phenylacridin in
22,0 Gt Propylenglykolmonomethylether.

Nach Auftragen einer Deckschicht aus Polyvinylalkohol wurden die Platten in gleicher Weise wie in Beispiel 1 belichtet und entwickelt. Es wurde die folgende Anzahl vollvernetzter Keilstufen erhalten:

Tabelle III

| Farbstoff (C.I. Nr.) | Belichtungszeit | Graufilter | Kantenfilter | Keilstufen |
|---|---|---|---|---|
| Hämatoporphyrin | 40 | ja | - | 7 |
| | 40 | nein | 455 | 8 |
| 2,3,7-Trihydroxy-9-phenyl-xanthen-6-on | 40 | ja | - | 9 |
| | 40 | nein | 455 | 5 |
| Thionin (52 000) | 40 | ja | - | 1 |
| | 40 | nein | 455 | 1/2 |
| Cyanosin (45 410) | 40 | ja | - | 10 |
| | 40 | nein | 455 | 9 |

Tabelle III (Fortsetzung)

| Farbstoff (C.I. Nr.) | Belichtungs-zeit | Grau-filter | Kanten-filter | Keil-stufen |
|---|---|---|---|---|
| 2,7-Dichlor- | 40 | ja | - | 10 |
| fluorescein | 40 | nein | 455 | 7 |
| Vitamin $B_2$ | 40 | ja | - | 11 |
| | 40 | nein | 455 | 2 |
| Eosin J | 40 | ja | - | 9 |
| (45 380) | 40 | nein | 455 | 10 |
| Bengalrosa | 40 | ja | - | 11 |
| | 40 | nein | 455 | 2 |
| Erythrosin | 40 | ja | - | 9 |
| (45 430) | 40 | nein | 455 | 11 |
| Acriflaviniumchlorid | 40 | ja | - | 7 |
| Hydrochlorid | 40 | nein | 455 | 3 |
| Rhodamin 6 G | 40 | ja | - | 10 |
| (45 160) | 40 | nein | 455 | 3 |
| 4'-Amino- | 40 | ja | - | 10 |
| fluorescein | 40 | nein | 455 | 3 |

Beispiel 3

Auf den in Beispiel 1 angegebenen Schichtträger wurde eine Lösung folgender Zusammensetzung so aufgeschleudert, daß ein Schichtgewicht von 2,5 g/$m^2$ erhalten wurde:
4,0 Gt der in Beispiel 1 angegebenen Copolymerisatlösung,
1,4 Gt Verbindung 1,
0,02 Gt Eosin (C.I. 45 386),
0,03 Gt Halogenverbindung und
0,049 Gt 9-Phenylacridin in
20,0 Gt Propylenglykolmonomethylether.

Die Platten wurden in gleicher Weise wie im Beispiel 1 verarbeitet. Nach 40 Sekunden Belichtungszeit wurde die folgende Anzahl vollvernetzter Keilstufen erhalten:

Tabelle IV

| Halogenverbindung | Graufilter | Kantenfilter | Stufen |
|---|---|---|---|
| 2-(4-Trichlormethyl-benzoylmethylen)-3-ethylbenzothiazolin | ja | - | 4 |
| | nein | 455 | 4 |
| 2,4-Bis-trichlormethyl-6-methyl-s-triazin | ja | - | 7 |
| | nein | 455 | 6 |

Tabelle IV (Fortsetzung)

| Halogenverbindung | Graufilter | Kantenfilter | Stufen |
|---|---|---|---|
| 2,4-Bis-trichlormethyl-6-phenyl-s-triazin | ja | - | 11 |
| | nein | 455 | 11 |
| Phenyl-tribrommethyl-sulfon | ja | - | 10 |
| | nein | 455 | 9 |

## Beispiel 4

Die Druckplatte aus Beispiel 1 mit der Verbindung 1 wurde mit dem aufgeweiteten Strahl eines Argon-Ionen-Lasers belichtet und wie in Beispiel 1 weiterverarbeitet.

Die Belichtungsergebnisse waren wie folgt:

| Wellenlänge (nm) | Energie im Laserstrahl ($mW/cm^2$) | Belichtungszeit (Sekunden) |
|---|---|---|
| 488,0 | 2 | 10 |

Mit diesen Platten durchgeführte Druckversuche lieferten über 100.000 einwandfreie Drucke.

Beispiel 5

Auf den in Beispiel 1 angegebenen Schichtträger wurde eine Lösung folgender Zusammensetzung so aufgeschleudert, daß ein Schichtgewicht von 2,0 g/$m^2$ erhalten wurde:
2,8 Gt der in Beispiel 1 angegebenen Copolymerisatlösung,
0,7 Gt Verbindung 1,
1,31 Gt einer 53,5 %igen Lösung des Umsetzungsprodukts von 2,2,4-Trimethyl-hexamethylendiisocyanat mit 2 mol Hydroxyethylmethacrylat in Butanon,
0,02 Gt Eosin,
0,03 Gt 2,4-Bis-trichlormethyl-6-(4-styryl-phenyl)-s-triazin und
0,049 Gt 9-Phenylacridin in
22,0 Gt Propylenglykolmonomethylether.

Die Platte wurde in gleicher Weise wie im Beispiel 1 verarbeitet. Nach 40 Sekunden Belichtung wurde jeweils die folgende Anzahl vollvernetzter Keilstufen erhalten:

| Graufilter | Kantenfilter | Stufen |
|---|---|---|
| ja | - | 6 |
| nein | 455 | 7 |

Beispiel 6

Auf den in Beispiel 1 angegebenen Schichtträger wurden unter gleichen Bedingungen wie dort Lösungen folgender Zusammensetzung aufgeschleudert:
4,0 Gt der in Beispiel 1 angegebenen Copolymerisatlösung,
1,4 Gt Verbindung 1,
0,02 Gt Eosin,
0,03 Gt 2,4-Bis-trichlormethyl-6-(4-styryl-phenyl)-s-triazin,
0,049 Gt 9-Phenylacridin und
0,1 Gt Carbonylverbindung in
22,0 Gt Propylenglykolmonomethylether
Die beschichteten Platten wurden wie im Beispiel 1 getrocknet und mit einer Deckschicht versehen. Die Belichtung erfolgte unter einem Interferenz-Verlauffilter von 400 bis 700 nm mit parallelem Licht einer 500 W-Glühbirne im Abstand von 75 cm. Nach Entwickeln wie in Beispiel 1 wurde in den angegebenen Spektralbereichen vollständige Aushärtung gefunden:

| Carbonylverbindung | Belichtungszeit (Sekunden) | Spektralbereich (nm) |
|---|---|---|
| 4-Dimethylamino-4'-methoxy-dibenzalaceton | 45 | 400-570 |
| 3-Acetal-7-diethylamino-cumarin | 45 | 420-580 |

Ohne Carbonylverbindung erhielt man nach 45 Sekunden einen ausgehärteten Bereich von 400-430 nm und von 450-570 nm. Ohne Carbonylverbindung und ohne Farbstoff erhielt man einen gehärteten Bereich von 400-430 nm.

Die Wirksamkeit der zugesetzten Verbindungen hinsichtlich des Auflösungsvermögens wurde mit einer Testvorlage, dem FOGRA-PMS-Keil, bestimmt und an der Kopie abgelesen. Das oben angegebene Gemisch ohne Dibenzalaceton- oder Cumarinderivat ergab jeweils eine um mindestens eine Stufe im K-Feld der Testvorlage schlechtere Auflösung.

Beispiel 7

Die Beschichtungslösung aus Beispiel 4 wurde auf eine biaxial verstreckte 35µm dicke Polyethylenterephthalatfolie so aufgeschleudert, daß nach dem Trocknen ein Schichtgewicht von 5 g/$m^2$ erhalten wurde. Die Schicht wurde 3 Minuten bei 100° C im Umlufttrockenschrank nachgetrocknet. Anschließend wurde die Schicht bei 115° C mit 1,5 m/s auf einen gereinigten Träger laminiert, der aus einem Isoliermaterial mit

35µm Kupferauflage bestand.

Die Schicht wurde mittels einer 5 kW-Metallhalogenidlampe (140 cm Abstand) unter einem Kantenfilter 455, wie im Beispiel 1 beschrieben, und unter einem Stufenkeil 30 Sekunden belichtet und nach Abziehen der Folie mit 0,8 %iger Sodalösung in einem Sprühprozessor 20 Sekunden entwickelt. Es wurden 4 vollvernetzte Keilstufen erhalten. Die vernetzte Schicht war gegen die in der Leiterplattentechnik übliche Eisen-III-chlorid-Lösung resistent. Die Ätzfestigkeit war gut.

Beispiel 8

Auf den in Beispiel 1 angegebenen Schichtträger wurde unter gleichen Bedingungen wie dort eine Lösung folgender Zusammensetzung aufgeschleudert:
4,0 Gt der in Beispiel 1 angegebenen Copolymerisatlösung,
1,4 Gt Verbindung 1,
0,02 Gt Eosin alkohollöslich,
0,03 Gt des Triazins aus Beispiel 6 und
0,02 Gt 4-Dimethylamino-4'-methoxydibenzalaceton in
22,0 Gt Propylenglykolmonomethylether.

Die beschichtete Platte wurde wie in Beispiel 1 getrocknet und mit einer Deckschicht versehen. Nach 10 Sekunden Belichten und Entwickeln wie im Beispiel 1 erhielt man mit Graufilter 2 und mit Kantenfilter 455 nm 7 vollgedeckte Stufen.

**Patentansprüche**

**1.** Photopolymerisierbares Gemisch, das als wesentliche Bestandteile
a) ein polymeres Bindemittel,
b) einen Acryl- oder Alkacrylsäureester eines mehrwertigen Alkohols und
c) einen photoreduzierbaren Farbstoff als Photoinitiator
enthält, dadurch gekennzeichnet, daß es ferner
d) eine durch Strahlung spaltbare Trihalogenmethylverbindung und
e) eine als Photoinitiator wirksame Acridin-, Phenazin oder Chinoxalinverbindung
enthält und daß der Acryl- oder Alkacrylsäureester mindestens eine bei Belichtung in Gegenwart des photoreduzierbaren Farbstoffs photooxydierbare Gruppe, aber keine Urethangruppe aufweist.

**2.** Gemisch nach Anspruch 1, dadurch gekennzeichnet, daß der Acryl- oder Alkacrylsäureester eine Verbindung der Formel I

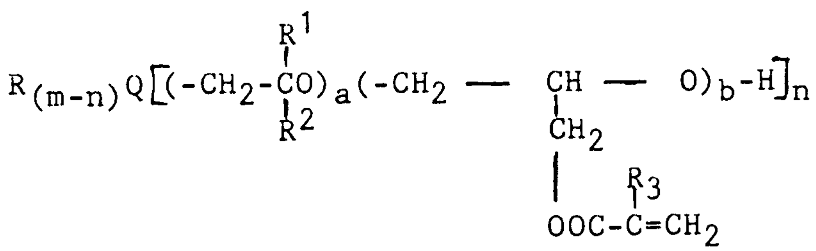

(I)

ist, worin
Q

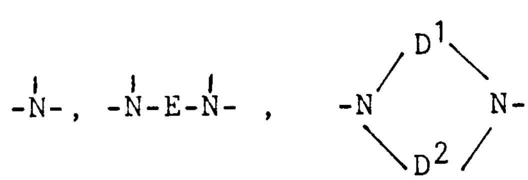

oder -S-,

R eine Alkyl-, Hydroxyalkyl- oder Arylgruppe,
$R^1$ und $R^2$ jeweils ein Wasserstoffatom, eine Alkylgruppe oder Alkoxyalkylgruppe,
$R^3$ ein Wasserstoffatom, eine Methyl- oder Ethylgruppe,
$D^1$ und $D^2$ jeweils eine gesättigte Kohlenwasserstoffgruppe mit 1 bis 5 Kohlenstoffatomen,
E eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen, eine heterocyclische aromatische Gruppe mit 5 oder 6 Ringgliedern oder eine Gruppe der Formel II

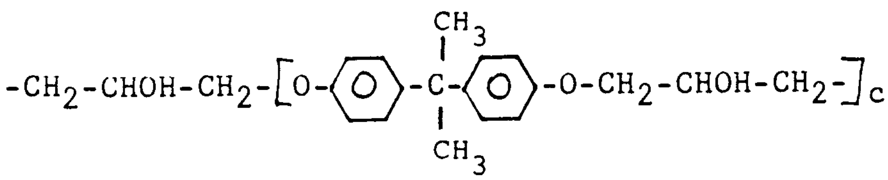
(II) ,

a und b ganze Zahlen von 1 bis 4,
c eine ganze Zahl von 1 bis 3,
m je nach Wertigkeit von Q 2, 3 oder 4 und
n eine ganze Zahl von 1 bis m

bedeutet, wobei alle Reste gleicher Definition untereinander gleich oder verschieden sein können.

**3.** Gemisch nach Anspruch 2, dadurch gekennzeichnet, daß n = m ist.

**4.** Gemisch nach Anspruch 2, dadurch gekennzeichnet, daß $R^3 = CH_3$ ist.

**5.** Gemisch nach Anspruch 2, dadurch gekennzeichnet, daß a = 1 ist.

**6.** Gemisch nach Anspruch 1, dadurch gekennzeichnet, daß der photoreduzierbare Farbstoff ein Xanthen-, Thiazin-, Porphyrin- oder Acridinfarbstoff ist.

**7.** Gemisch nach Anspruch 6, dadurch gekennzeichnet, daß der Xanthenfarbstoff eine Verbindung der Formel III

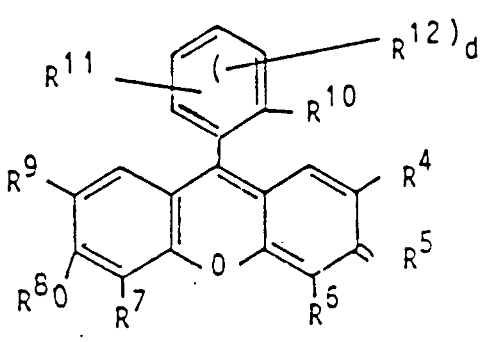
(III)

ist, worin

$R^4$ und $R^9$ gleich oder verschieden sind und Wasserstoff- oder Halogenatome, Nitro- oder Hydroxygruppen oder Gruppen der Formel -HgOH bedeuten,
$R^6$ und $R^7$ gleich oder verschieden sind und Wasserstoff- oder Halogenatome oder Hydroxygruppen,
$R^5$ O oder $^{(+)}$NHAlkyl $X^{(-)}$,
$R^8$ ein Wasserstoffatom, ein Alkalimetall-, Ammonium- oder Trialkylammoniumkation, eine Alkyl- oder Acylgruppe,
$R^{10}$ ein Wasserstoffatom oder eine Gruppe $COOR^{13}$,

$R^{11}$ ein Wasserstoff- oder Halogenatom oder eine Aminogruppe,
$R^{12}$ ein Wasserstoff- oder Halogenatom,
$R^{13}$ ein Wasserstoffatom, ein Alkalimetall- oder Ammoniumkation, eine Alkylgruppe oder ein polymerer Rest,
X ein Anion und
d Null oder eine ganze Zahl von 1 bis 3 bedeutet.

**8.** Gemisch nach Anspruch 6, dadurch gekennzeichnet, daß der Farbstoff eine Verbindung der Formel IV

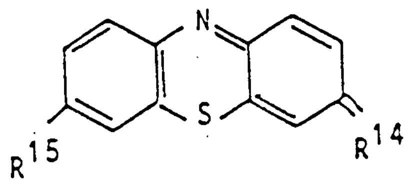

(IV)

ist, worin
$R^{14}$ eine der Gruppen $=NH_2^{(+)}X^{(-)}$, $=NHAlkyl^{(+)}X^{(-)}$ und $=N(Alkyl)_2^{(+)}X^{(-)}$,
$R^{15}$ eine Amino-, Alkylamino- oder Dialkylaminogruppe und
X ein Anion ist.

**9.** Gemisch nach Anspruch 1, dadurch gekennzeichnet, daß die durch Strahlung spaltbare Trihalogenmethylverbindung ein s-Triazin, das durch mindestens eine Trihalogenmethylgruppe und eine weitere Gruppe substituiert ist, oder ein Aryltrihalogenmethylsulfon ist.

**10.** Gemisch nach Anspruch 9, dadurch gekennzeichnet, daß die weitere Gruppe mindestens einen aromatischen Kern enthält, der direkt oder über ein durchkonjugiertes Doppelbindungssystem mit dem Triazinrest verbunden ist.

**11.** Gemisch nach Anspruch 1, dadurch gekennzeichnet, daß das Bindemittel wasserunlöslich und in wäßrig-alkalischen Lösungen löslich ist.

**12.** Gemisch nach Anspruch 1, dadurch gekennzeichnet, daß es 10 bis 80 Gew.-% Acryl- oder Alkacrylsäureester, 20 bis 90 Gew.-% polymeres Bindemittel und 0,05 bis 20 Gew.-%, bezogen auf die nichtflüchtigen Bestandteile des Gemischs, an strahlungsaktivierbaren Polymerisationsinitiatoren (c), (d) und (e) enthält.

**13.** Photopolymerisierbares Gemisch nach Anspruch 1, dadurch gekennzeichnet, daß es zusätzlich eine Dibenzalaceton- oder Cumarinverbindung (f) enthält.

**14.** Photopolymerisierbares Aufzeichnungsmaterial mit einem Schichtträger und einer photopolymerisierbaren Schicht, dadurch gekennzeichnet, daß die photopolymerisierbare Schicht aus einem Gemisch gemäß Anspruch 1 besteht.

## Claims

**1.** A photopolymerizable mixture which contains, as essential components,
a) a polymeric binder,
b) an acrylate or alkacrylate of a polyhydric alcohol, and
c) a photoreducible dye as photoinitiator,
characterized in that it furthermore contains
d) a trihalomethyl compound which can be cleaved by irradiation, and
e) an acridine, phenazine or quinoxaline compound which acts as photoinitiator,
and that the acrylate or alkacrylate contains at least one group which is photooxidizable on exposure in the presence of the photoreducible dye, but no urethane group.

**2.** A mixture as claimed in claim 1, characterized in that the acrylate or alkacrylate is a compound of the formula I

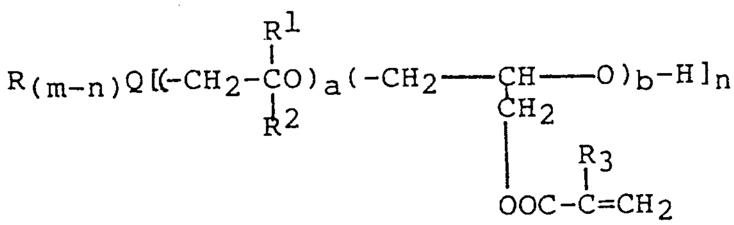

(I)

in which

Q denotes

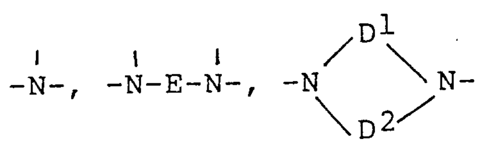

or -S-,

R denotes an alkyl, hydroxyalkyl or aryl group,

$R^1$ and $R^2$ each denote a hydrogen atom, an alkyl group or an alkoxyalkyl group,

$R^3$ denotes a hydrogen atom, a methyl group or an ethyl group,

$D^1$ and $D^2$ each denote a saturated hydrocarbon group having 1 to 5 carbon atoms,

E denotes a saturated hydrocarbon group having 2 to 12 carbon atoms, a cycloaliphatic group having 5 to 7 ring members and optionally containing up to two N, O or S atoms as ring members, an arylene group having 6 to 12 carbon atoms, a heterocyclic aromatic group having 5 or 6 ring members or a group of the formula II

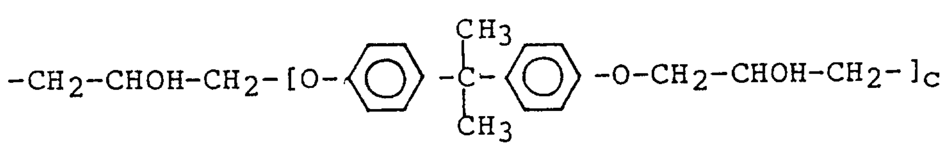

(II)

a and b denote integers from 1 to 4,

c denotes an integer from 1 to 3,

m denotes 2, 3 or 4, depending on the valency of Q, and

n denotes an integer from 1 to m,

whereby all radicals of the same definition may be identical to or different from one another.

**3.** A mixture as claimed in claim 2, wherein $n = m$.

**4.** A mixture as claimed in claim 2, wherein $R^3 = CH_3$.

**5.** A mixture as claimed in claim 2, wherein $a = 1$.

**6.** A mixture as claimed in claim 1, wherein the photoreducible dye is a xanthene, thiazine, porphyrine or acridine dye.

**7.** A mixture as claimed in claim 6, wherein the xanthene dye is a compound of the formula III

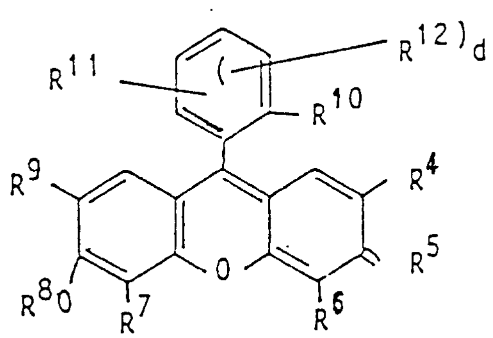

(III)

in which

| | |
|---|---|
| $R^4$ an $R^9$ | are identical or different and denote hydrogen or halogen atoms, nitro or hydroxy groups or groups of the formula -HgOH, |
| $R^6$ and $R^7$ | are identical or different and denote hydrogen or halogen atoms or hydroxy groups, |
| $R^5$ | denotes oxygen or $^{(+)}$NHalkyl $X^{(-)}$, |
| $R^8$ | denotes a hydrogen atom, an alkali metal, ammonium or trialkylammonium cation, or an alkyl or acyl group, |
| $R^{10}$ | denotes a hydrogen atom or a $COOR^{13}$ group, |
| $R^{11}$ | denotes a hydrogen or halogen atom or an amino group, |
| $R^{12}$ | denotes a hydrogen or halogen atom, |
| $R^{13}$ | denotes a hydrogen atom, an alkali metal or ammonium cation, an alkyl group or a polymeric radical, |
| X | denotes an anion, and |
| d | denotes zero or an integer from 1 to 3. |

**8.** A mixture as claimed in claim 6, wherein the dye is a compound of the formula IV

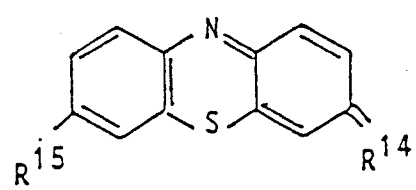

(IV)

in which

| | |
|---|---|
| $R^{14}$ | is one of the groups $=NH_2^{(+)}X^{(-)}$, $=NHalkyl^{(+)}X^{(-)}$ and $=N(alkyl)_2^{(+)}X^{(-)}$, |
| $R^{15}$ | is an amino, alkylamino or dialkylamino group, and |
| X | is an anion. |

**9.** A mixture as claimed in claim 1, wherein the trihalomethyl compound which can be cleaved by irradiation is an s-triazine which is substituted by at least one trihalomethyl group and one further group or is an aryl trihalomethyl sulfone.

**10.** A mixture as claimed in claim 9, wherein the further group contains at least one aromatic nucleus which is connected to the triazine radical either directly or via a conjugated double bond system.

**11.** A mixture as claimed in claim 1, wherein the binder is insoluble in water and soluble in aqueous-alkaline solutions.

**12.** A mixture as claimed in claim 1, which contains 10 to 80 % by weight of acrylate or alkacrylate, 20 to 90 % by weight of polymeric binder and 0.05 to 20 % by weight, relative to the nonvolatile constituents of the mixture, of radiation-activatable polymerization initiators (c), (d) and (e).

**13.** A photopolymerizable mixture as claimed in claim 1, which additionally contains a dibenzal acetone or coumarine compound (f).

**14.** A photopolymerizable recording material comprising a layer support and a photopolymerizable layer, wherein the photopolymerizable layer comprises a mixture as claimed in claim 1.

**Revendications**

**1.** Composition photopolymérisable, qui contient comme constituants principaux:
a) un liant polymère,
b) un ester d'acide acrylique ou alkylacrylique et d'un polyol, et
c) un colorant photoréductible comme amorceur photochimique,
caractérisée en ce qu'elle contient en outre:
d) un composé trihalogénométhylé clivable par irradiation, et
e) un composé d'acridine, de phénazine ou de quinoxaline, actif comme amorceur photochimique,
et que l'ester d'acide acrylique ou alkylacrylique possède un ou plusieurs groupe(s) photooxydable(s) par exposition à la lumière en présence du colorant photoréductible, mais pas de groupe uréthane.

**2.** Composition selon la revendication 1, caractérisée en ce que l'ester d'acide acrylique ou d'acide alkylacrylique est un composé de formule I

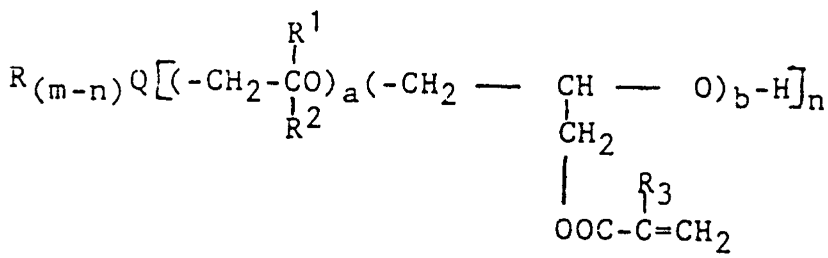

(I)

dans laquelle les différents symboles représentent:
Q

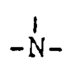, 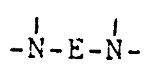 , 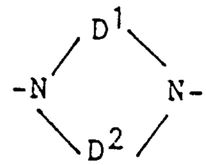

ou -S-,

R un groupe alkyle, hydroxyalkyle ou aryle,
$R^1$ et $R^2$ chacun un atome d'hydrogène, un groupe alkyle ou un groupe alcoxyalkyle,
$R^3$ l'atome d'hydrogène ou un groupe méthyle ou éthyle,
$D^1$ et $D^2$ chacun un groupe hydrocarboné saturé en $C_{1-5}$,
E un groupe hydrocarboné saturé en $C_{2-12}$, un groupe cycloaliphatique comportant de 5 à 7 chaînons, qui renferment éventuellement jusqu'à deux atomes N, O ou S comme chaînons cycliques, un groupe arylène en $C_{6-12}$ ou un groupe aromatique hétérocyclique pentagonal ou hexagonal, ou un groupe de formule II:

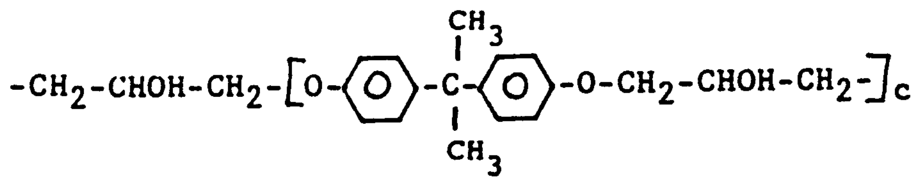 (II) ,

| | |
|---|---|
| a et b | des nombres entiers de 1 à 4, |
| c | un nombre entier de 1 à 3, |
| m | selon la valence de Q: 2, 3 ou 4, et |
| n | un nombre entier de 1 à m, |

tous les radicaux de même définition pouvant être identiques ou différents les uns des autres.

**3.** Composition selon la revendication 2, caractérisée en ce que $n = m$.

**4.** Composition selon la revendication 2, caractérisée en ce que $R^3 = CH_3$.

**5.** Composition selon la revendication 2, caractérisée en ce que $a = 1$.

**6.** Composition selon la revendication 1, caractérisée en ce que le colorant photoréductible est un colorant xanthène, thiazine, porphyrine ou acridine.

**7.** Composition selon la revendication 6, caractérisée en ce que le colorant xanthène est un composé de formule III

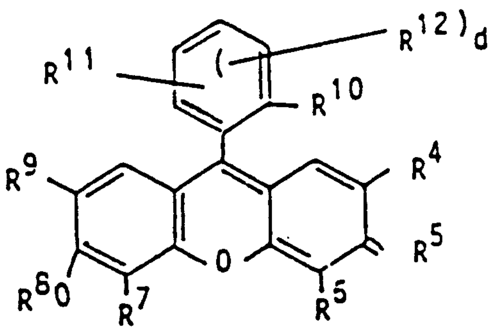 (III)

dans laquelle

| | |
|---|---|
| $R^4$ et $R^9$, | identiques ou différents, représentent des atomes d'hydrogène ou d'halogène, des groupes nitro ou hydroxyle ou des groupes de formule HgOH, |
| $R^6$ et $R^7$, | identiques ou différents, représentent des atomes d'hydrogène ou d'halogène ou des groupes hydroxyle, |
| $R^5$ | représente O ou $^{(+)}$NHalkyl $X^{(-)}$, |
| $R^8$ | représente l'atome d'hydrogène, un cation de métal alcalin, ammonium ou trialkylammonium, un groupe alkyle ou acyle, |
| $R^{10}$ | représente l'atome d'hydrogène ou un groupe $COOR^{13}$, |
| $R^{11}$ | représente un atome d'hydrogène ou d'halogène ou un groupe amino, |
| $R^{12}$ | représente un atome d'hydrogène ou d'halogène, |
| $R^{13}$ | représente l'atome d'hydrogène, un cation de métal alcalin ou un cation ammonium, un groupe alkyle ou un radical polymère, |
| X | représente un anion, et |
| d | vaut O ou est un nombre entier de 1 à 3. |

**8.** Composition selon la revendication 6, caractérisée en ce que le colorant est un composé de formule IV

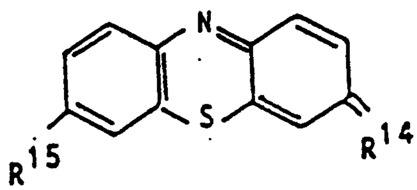

(IV)

dans laquelle
$R^{14}$ est un des groupes $=NH_2^{(+)}X^{(-)}$, $=NHalkyl^{(+)}X^{(-)}$ et $=N\ (alkyl)_2^{(+)}X^{(-)}$,
$R^{15}$ représente un groupe amino, alkylamino ou dialkylamino, et X est un anion.

**9.** Composition selon la revendication 1, caratérisée en ce que le composé trihalogénométhylé clivable par rayonnement est une s-triazine qui est substituée par au moins un groupe tribalogénométhyle et par un autre groupe, ou bien une aryltrihalogénométhylsulfone.

**10.** Composition selon la revendication 9, caractérisée en ce que l'autre groupe contient au moins un noyau aromatique, qui est lié au reste triazine directement ou par l'intermédiaire d'un système de doubles liaisons conjuguées.

**11.** Composition selon la revendication 1, caractérisée en ce que le liant est insoluble dans l'eau et soluble dans les solutions hydro-alcalines.

**12.** Composition selon la revendication 1, caractérisée en ce qu'elle contient de 10 à 80 % en poids d'ester d'acide acrylique ou alkylacrylique, de 20 à 90 % en poids de liant polymère et de 0,05 à 20 % en poids, par rapport aux constituants non volatils de la composition, d'amorceurs de polymérisation (c), (d) et (e) activables par rayonnement.

**13.** Composition photopolymérisable selon la revendication 1, caractérisée en ce qu'elle contient en outre un composé de dibenzylidèneacétone ou de coumarine (f).

**14.** Matériau d'enregistrement reprographique photopolymérisable comprenant un support de couche et une couche photopolymérisable, caractérisé en ce que la couche photopolymérisable se compose d'un mélange selon la revendication 1.